# EUROPEAN PATENT APPLICATION

(11) **EP 2 267 466 A1**
(43) Date of publication of application: **29.12.2010**
(21) Application number: 10166677.4
(22) Date of filing: 21.06.2010
(51) Int. Cl.: G01R 21/06, G08B 13/14, H01L 31/042, G01R 31/02

(54) **Apparatus for measuring the voltage and current generated by photovoltaic panels**

(30) Priority: 23.06.2009 IT MO20090165
(71) Applicant: FAST S.P.A., 42048 Rubiera RE (IT)
(72) Inventor: Rossi, Ireno, 16030, COGORNO GE (IT)
(74) Representative: Modiano, Micaela Nadia

(57) **Abstract**

An apparatus (7) for measuring the current and voltage generated by a string of photovoltaic panels (3, 4, 5, 6) connected in series, each panel comprising at least one diode (33) that allows the passage of a flow of current. The apparatus comprises means (30) for detecting an interruption in the current in the connecting line between the panels of the string. The apparatus comprises means (50) for introducing an auxiliary current in the connecting line upon detection of a minimum limit value of electric power produced by the panels, the detection means (30) being adapted to detect the interruption of the auxiliary current introduced in the connecting line.

## Description

The present invention relates to an apparatus for measuring the voltage and current generated by a string of photovoltaic panels.

In recent years, the use of photovoltaic panel systems that utilize solar energy to generate electric power has developed considerably, so much that it has acquired a considerable market share in the field of renewable energy.

In a classic photovoltaic system, the panels are mutually connected in series, and in this regard one refers to a string of photovoltaic panels. Usually, a single photovoltaic system is composed of several strings arranged in parallel to each other and thus assumes the configuration of a grid of panels.

The combined action of the panels that belong to a same string allows the dispensing of electric power, which can be fed into the electric power distribution grid for use by one or more users.

Measurement of the voltages and currents generated by each individual string is essential in order to monitor the efficiency and productivity of the entire energy production system, and devices adapted to measure these values are already commercially available.

One problem that arises in relation to photovoltaic systems for power generation relates to the possible theft of such panels, particularly at night, when darkness inherently aids ill-intentioned individuals, who are also facilitated by the fact that since there is no sunlight the panels generate no electric power and therefore can be removed without any risk of electrical discharge.

Besides the possible use of traditional video surveillance methods or intrusion detection systems, devices have recently contrived which are connected electrically to the panels and which, as a function of the measurement of specific string parameters, such as for example the current or voltage generated by the string itself, already provide a surveillance function regarding the theft of such panels.

However, at night, and in general in periods of insufficient sunlight, these devices cannot be used, since a string appears as a voltage or current source that is off, and therefore even the removal of one or more panels does not alter the detected current or voltage measurements.

In order to obviate this drawback it would be necessary to provide within the photovoltaic system new wiring, with a consequent considerable expenditure in economic terms and in terms of space.

The aim of the present invention is to eliminate the drawbacks noted above, by providing an apparatus that is able to detect the energy, voltage and/or current parameters generated by each individual string and any disconnection due to theft or failure of one or more panels that compose the string, operating without the use of additional wiring with respect to known devices.

Within this aim, an object of the invention is to provide an apparatus that is capable of detecting malfunctions caused by removal or failure of a photovoltaic panel that belongs to a string even at night or in low-light situation, during which photovoltaic panels do not generate power and theft is further more likely.

Another object of the invention is to provide an apparatus that does not entail the use of complex devices but utilizes the potential of devices that are already commercially available and commonly used.

A further object of the invention is to provide an apparatus that is highly reliable, has a low environmental impact, is relatively easy to provide and at competitive costs.

This aim, as well as these and other objects that will become better apparent hereinafter, are achieved by an apparatus for measuring the current and voltage generated by a string of photovoltaic panels connected in series, each of said panels comprising at least one diode that allows the passage of a flow of current, comprising means for detecting an interruption in the current in the connecting line between said panels of said string, **characterized in that** it comprises means for introducing an auxiliary current in said connecting line upon detection of a minimum limit value of electric power produced by said panels, said detection means being adapted to detect the interruption of said auxiliary current introduced in said connecting line.

Further characteristics and advantages of the invention will become better apparent from the following detailed description of a preferred but not exclusive embodiment of the apparatus according to the invention, illustrated by way of non-limiting example in the accompanying drawings, wherein:

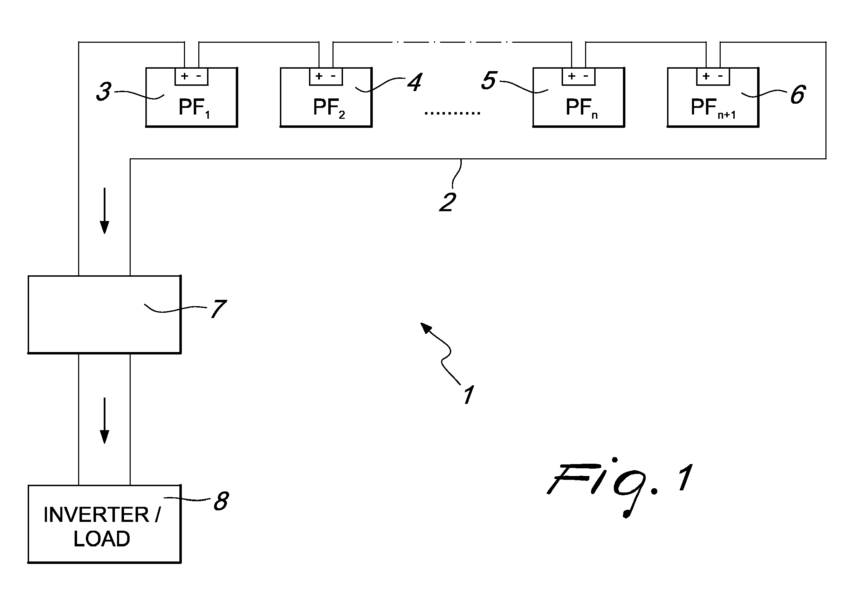

Figure 1 is a view of a system comprising the string of photovoltaic panels and the apparatus according to the invention;
Figure 2 is a block diagram of the apparatus with power supply from an external source and data transmission over wired networks, according to the background art;
Figure 3 is a block diagram of the apparatus with power supply from a string and data transmission in wireless mode, according to the invention;
Figure 4 is an electrical diagram of the apparatus according to the invention and of the connections to the input and the output of the string;
Figure 5 is an electrical diagram of the processing unit within the apparatus;

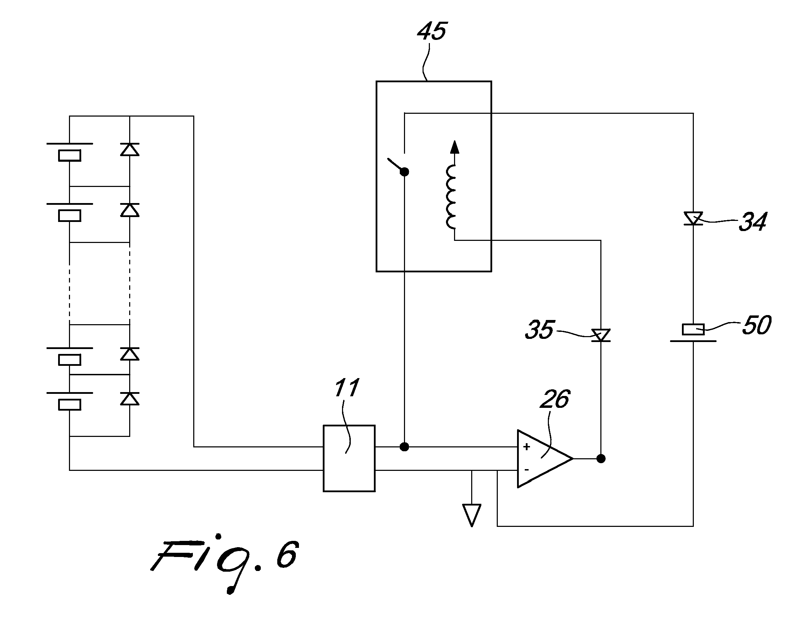

Figure 6 is an electrical diagram of the detection circuit within the apparatus.

With reference to the figures, a system according to the invention, generally designated by the reference numeral 1, is composed of photovoltaic panels 3, 4, 5, 6, which are all mutually identical and are connected by means of a single conductor 2 so as to form a string of panels.

The conductor 2, and therefore the string of photovoltaic panels, is connected to a measurement apparatus 7 according to the invention, which in turn is connected with its output to a load 8, preferably an inverter for generating an alternating voltage to be fed to the electrical distribution grid.

The measurement apparatus 7 has an input 11 of electrical current values from a string of panels, which is connected to a block 13 for measuring such signals that arrive from the input 11, which is provided with antitheft circuit functions.

There is also a block 12 for the output of the current values of the string, which is connected to a measurement block 13 and supplies the inverter 8 directly.

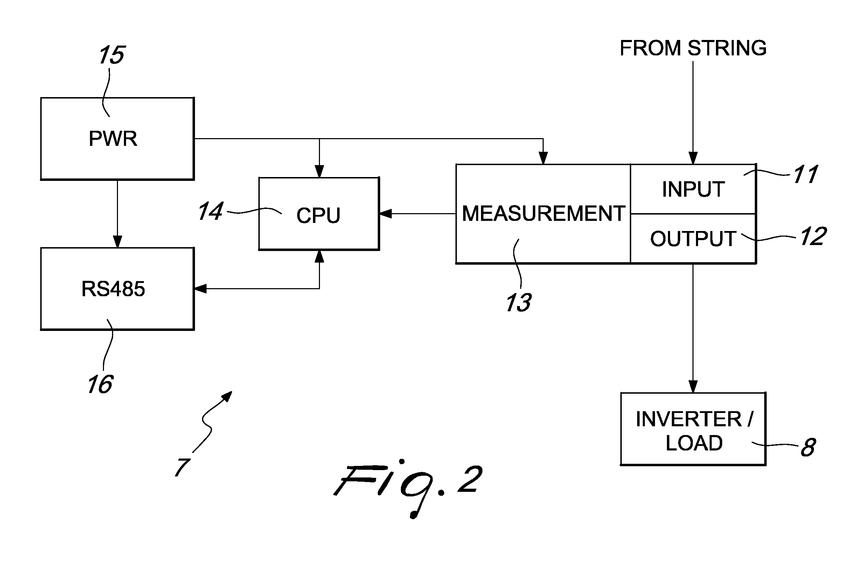

The measurement block 13 connects to a processing unit 14, advantageously a Central Processing Unit (CPU), which is connected to a system for monitoring the electric current values that arrive from the string and are subsequently processed, by way of communication means which advantageously comprise a serial line of the RS485 type or a wireless module. With reference to Figure 2, for example, the communication means comprise a serial line 16 of the RS485 type.

Power supply means 15, which are of the 12-volt DC type, are connected directly both to the measurement block 13 and to the CPU 14 and to the serial line 16, supplying power to them.

It should be noted that the DC power supply means 15 and the serial line 16 of the RS485 type are devices that are known in the background art.

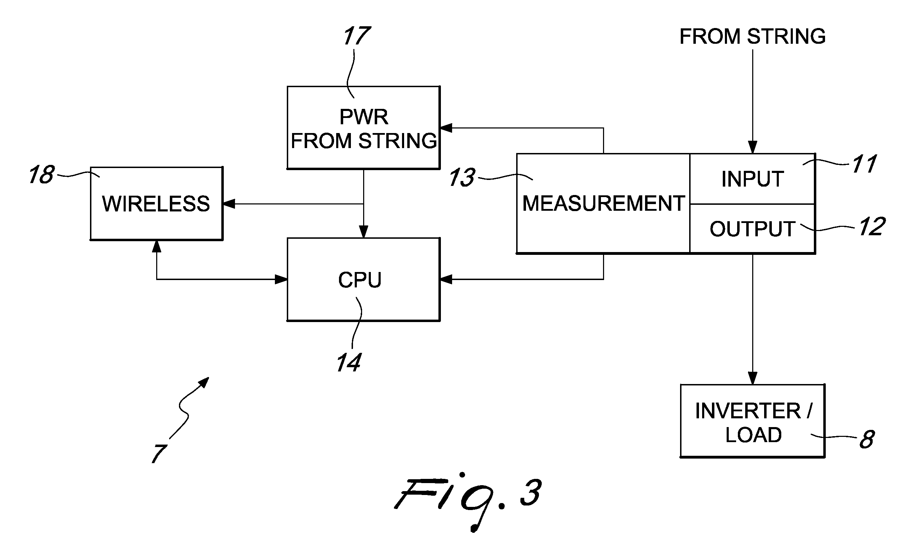

With reference to Figure 3, the block diagram of the apparatus 7 according to the invention is shown, wherein the input block 11 and the output block 12 directed toward the inverter 8 and the measurement block 13 are similar.

However, in this configuration power supply means 17 are constituted by the photovoltaic string and are connected to the measurement block 13, from which they receive the current or voltage that arrives from the string; optionally, in darkness situations in which the string does not generate voltage, power can be supplied by a backup battery that recharges in daylight.

Depending on the available energy, the power supply means 17 supply the CPU 14, which in turn is already connected to the measurement block 13.

From the CPU 14, the data are passed to the monitoring system by way of means of communication, which again advantageously comprise a serial line of the RS485 type or a wireless module. With reference to the embodiment of Figure 3, according to the invention, the communication means comprise in particular a wireless module 18, which also is powered by the power supply means 17.

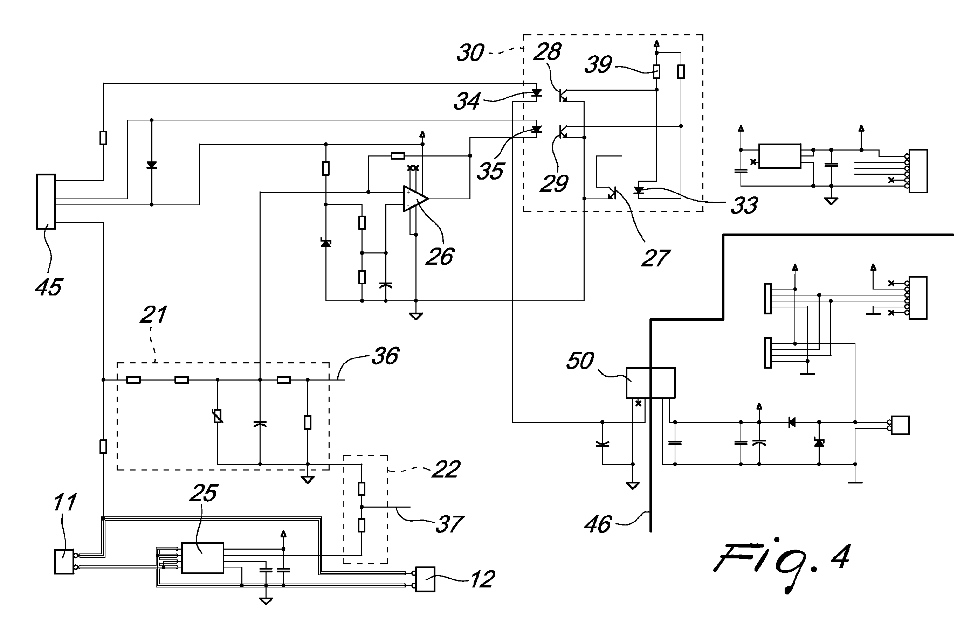

Inside the apparatus 7, the block 13 for measuring the current or voltage that arrives from the string has an electrical insulation 46, highlighted in Figure 4, both with respect to the power supply means, be they constituted by a 12-volt DC power supply or by the photovoltaic string, and with respect to the communication means, which comprise the serial line 16 of the RS485 type or the wireless module 18.

The electrical diagram of Figure 4 again highlights, within the apparatus 7, the input 11 and the output 12 of the current of the string, which are connected to a current measurement sensor 25, which is connected to a resistive divider 22.

The input 11 and the output 12 of the current of the string are further connected, again across a resistive divider 21, to the photovoltaic string.

The output of the two resistive dividers 21 and 22 are respectively two signals 36 and 37.

Within the apparatus 7 there is a comparator 26 and a detection circuit 30, which comprises optical couplers, constituted by transistors 28, 29 and by means for detecting an interruption in the connecting line between the panels of the string, i.e., diodes 34 and 35. The detection circuit 30 further comprises a transistor 27, which is coupled to a diode 33.

Moreover, a pull-up resistor 39 of the transistor 28 is connected to the detection circuit 30. The functions of these and other circuit components will become better apparent hereinafter.

The apparatus further comprises means for introducing an auxiliary current in the connecting line between the photovoltaic panels that constitute the string; such introduction means comprise a device 50, which is controlled by a relay 45.

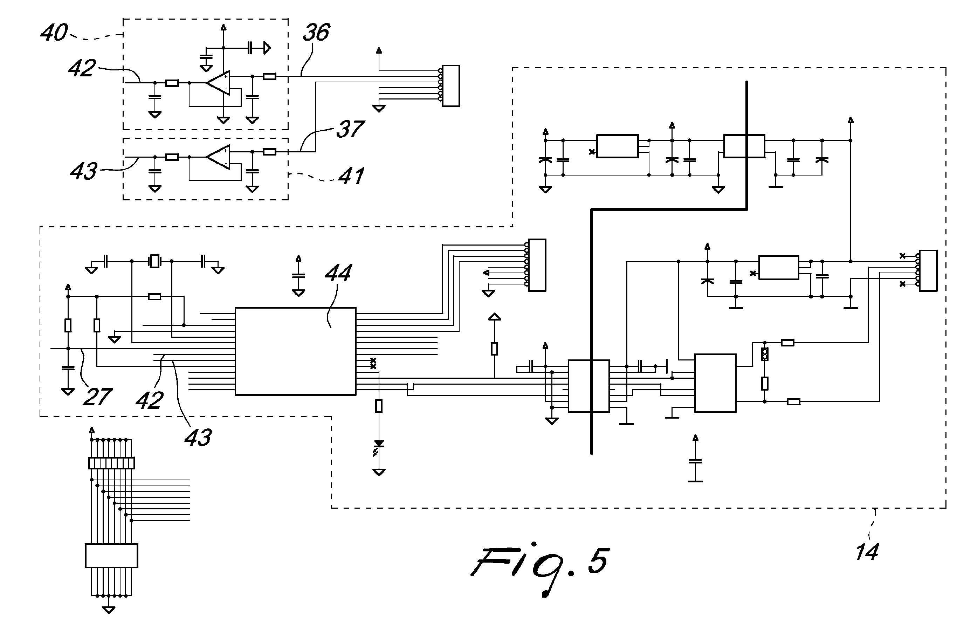

With reference to Figure 5, the electrical diagram of the CPU block 14 is shown, highlighting separately filters 40 and 41, the inputs of which are respectively the output signals 36 and 37 and respective output signals 42 and 43 of which are connected in input to an analog-digital converter 44 within the CPU 14.

The operation of the apparatus according to the invention is as follows.

The apparatus 7 measures the current and voltage levels generated by the action of the photovoltaic panels 3, 4, 5, 6 that belong to the string, which collect the energy that arrives from sunlight to then convert it into power, which supplies the inverter 8 for subsequent use in the electrical distribution grid.

The voltage generated by the string, which enters the apparatus 7 from the input 11, is reduced by the resistive divider 21. The value of the reduction constant, minus the tolerances on the chosen resistance values, is on the order of 10⁻³.

Since the maximum voltage that the internal circuitry of the apparatus 7 can withstand is equal to 3 volts, and since the voltage at the input 11 is the power supply 17 of the apparatus 7, accordingly such voltage at the input 11 cannot exceed a maximum value, which is set due to the reduction constant indicated above at approximately 800 volts.

One characteristic parameter of the string is represented by the current delivered toward the inverter 8.

For the purposes of the measurement of this string current, the Hall-type current measurement sensor 25 is used and supplies an output voltage that is proportional to the current that flows across it. Such sensor is inherently capable of measuring bidirectional currents, but in this case it is used only to measure currents that flow from the string toward the load 8.

The voltage generated by the sensor is divided by the resistive divider 22 and the output signal 37 is filtered and buffered by the filter 41; the additional output signal 43 is sent in input to the analog-digital converter 44 within the CPU 14.

Likewise, the voltage output signal 36, divided by the resistive divider 21, is filtered and buffered by the filter 40 and the output signal 42 is sent in input to the analog-digital converter 44 within the CPU 14.

The apparatus 7 lends itself to detecting any interruption of the series of photovoltaic panels that compose the string, a condition that can occur in case of theft or failure of at least one of the elements of the series and is accompanied by lack of generation of voltage on the part of the string.

The apparatus 7 is in fact capable of discriminating between the situation of theft or malfunction of one of the panels and the situation in which the string does not generate voltage simply because night has fallen or the day is not sunny. Besides, it is easy to understand for an ill-intentioned individual darkness is indeed the most favorable condition for approaching the system and stealing one or more panels, also because the lack of energy generation at night does not expose him to the risk of electrical discharges.

The power supply of the apparatus 7, if it occurs by means of the self-powering means 17 of the apparatus from the photovoltaic string, cannot be ensured at night or in darkness by the string of panels, since in this situation the string does not generate voltage; in this case, the power supply is ensured by a backup battery, which recharges during the day or when light is available. Further, this allows to preserve an antitheft function if an interruption in the connection among the panels of the string is detected, for example by sending an alarm signal to a video surveillance or monitoring system.

This signal is sent by way of the communication means, be they the serial line 16 of the RS485 type or the wireless module 18; in this second case, if there are no anomalies the wireless module 18 is advantageously kept in standby mode and awakened only periodically, every minute, to transmit the voltage and current values measured by the apparatus 7, so as to preserve the charge of the battery. As soon as a string interruption is detected, the wireless module 18 is instead awakened instantaneously in order to send a timely alarm signal to the monitoring system.

For the purpose of detecting any interruption in the connecting line among the panels that constitute the string, a threshold value of the voltage generated by the string of photovoltaic panels, adjusted to a value substantially equal to 65 volts, is set.

If the measurement block 13 within the apparatus 7 detects a string voltage value lower than 65 volts, the device 50 for introducing auxiliary current is connected in series to the string of panels and, enabled by the relay 45, injects such auxiliary current within the string.

Measurement of the lack of continuity of current is performed by the detection circuit 30 composed of the optical couplers, each formed by the diodes 34, 35 and 33 and by the respective transistors 28, 29 and 27.

If the voltage is lower than 65 volts, the comparator 26 closes its output toward the ground, energizing the coil of the relay 45; the coil crossing current also crosses the diode 35, closing the corresponding transistor 29 toward the ground and consequently grounding the cathode of the diode 33.

Energizing the coil of the relay 45 closes the contact of such relay, making the inverse auxiliary current generated by the device 50 flow across the string of panels, which are connected correctly, and the diodes 34. In this condition, the transistor 28 conducts toward the ground, ensuring that current does not flow across the diode 33.

If the conductor 2 of the string of panels is interrupted, the flow of auxiliary current is also interrupted and no longer flows in the diode 34. A consequence of this is that the transistor 28 assumes the open state, and the current that flows through the resistor 39 is diverted onto the diode 33, which, since its cathode is already connected to the ground by the transistor 29, is crossed by such current; therefore, the transistor 27 changes state and closes. This situation is detected by the analog-digital converter 44, which activates within the CPU 14 the alarm procedure.

In practice it has been found that the apparatus according to the invention fully achieves the intended aim, since it allows to measure the voltage and current generated by a string of photovoltaic panels and further allows to detect any interruption in the connecting line among the photovoltaic panels that belong to the string. In this manner, it is possible to ascertain safely whether one of the panels has been stolen or has failed, by means of the detection or lack thereof of the flow of an auxiliary current that is circulated within the string when, for example at night or in any case when there is no light, power generation by the string of panels drops below a given threshold.

Detection or lack of detection of such auxiliary current flow in fact discriminates between the situation in which energy generation is low merely due to lack of light and the situation in which a theft or a failure of one of the panels has occurred.

Although the apparatus according to the invention has been conceived in particular to measure the current and the voltage generated by a string of photovoltaic panels and to detect any theft or fault of one of them, it can in any case be used more generally within a surveillance and/or antitheft system provided with an electronic controller, to manage and supervise the photovoltaic plant and send information to individuals in charge or security companies both in Web mode and according to mobile telephony standards such as GSM, GPRS, EDGE, UMTS.

The device thus conceived is susceptible of numerous modifications and variations, all of which are within the scope of the appended claims; all the details may further be replaced with other technically equivalent elements.

In practice, the materials used, as well as the dimensions, may be any according to requirements and to the state of the art.

The disclosures in Italian Patent Application No. MO2009A000165 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. An apparatus (7) for measuring the current and voltage generated by a string of photovoltaic panels (3, 4, 5, 6) connected in series, each of said panels comprising at least one diode (33) that allows the passage of a flow of current, comprising means (30) for detecting an interruption in the current in the connecting line between said panels of said string, **characterized in that** it comprises means (50) for introducing an auxiliary current in said connecting line upon detection of a minimum limit value of electric power produced by said panels, said detection means being adapted to detect the interruption of said auxiliary current introduced in said connecting line.

2. The apparatus according to claim 1, **characterized in that** said detection means comprise a circuit (30) for detecting said auxiliary current, said detection circuit (30) being provided with optical couplers.

3. The apparatus according to claim 1, **characterized in that** it comprises means (16, 18) for reporting to a monitoring system the interruption of said auxiliary current introduced in said connecting line, said reporting means (16, 18) comprising a serial line (16) or a wireless module (18).

4. The apparatus according to one or more of the preceding claims, **characterized in that** it comprises means (15, 17) for supplying power to said apparatus by means of a supply from electrical mains or from a backup battery or by self-powering from said panels of said string (17).
